Europäisches Patentamt

European Patent Office

Office européen des brevets

(19)

(11) Publication number: **0 580 924 A1**

# EUROPEAN PATENT APPLICATION

(12)

(21) Application number: **92830429.4**

(22) Date of filing: **30.07.92**

(51) Int. Cl.⁵: **H03H 1/00,** H03H 17/02, H03H 17/06

(43) Date of publication of application:
**02.02.94 Bulletin 94/05**

(84) Designated Contracting States:
**DE FR GB IT**

(71) Applicant: **SGS-THOMSON MICROELECTRONICS s.r.l.**
Via C. Olivetti, 2
I-20041 Agrate Brianza Milano(IT)

(72) Inventor: **Cremonesi, Alessandro**
Via Cabrini 89
I-20079 Sant'Angelo Lodigiano(IT)
Inventor: **Scalise, Fabio Mario**
Via Fracchia 4
I-20125 Milano(IT)

(74) Representative: **Prato, Roberto et al**
STUDIO TORTA Società Semplice
Via Viotti 9
I-10121 Torino (IT)

(54) **Digital filter device.**

(57) A filter device (1) comprising a multi-plexer/demultiplexer stage (3) supplied with an input signal including a number of samples, which stage (3) presents two outputs (4, 5) alternatively supplying the samples of the input signal, and each of which thus presents a signal at half the frequency of the input signal. Each output (4, 5) is connected to a respective half filter (18, 23) for filtering the samples, and the filtered samples of both half filters are supplied to an adder (22) so that the filtered signal at the output (26) of the adder (22) presents half the frequency of the input signal. The filters (18, 23) comprise memories addressed by the samples of the signal and storing the filtering coefficient products of all the possible sample values.

Fig.1

EP 0 580 924 A1

The present invention relates to a digital filter device, in particular, a finite impulse response (FIR) filter.

The input data sampling frequency of known digital filters is normally equal to the maximum internal operating frequency of the filter, even when a reduction in output frequency is required. This therefore limits the maximum frequency of the input signal that can be processed by the filter. What is more, two separate filter devices are required for filtering two different input channels at maximum operating frequency.

In addition to increasing cost, duplication of the filter devices also results in complex design and poor reliability of the overall structure.

It is an object of the present invention to provide a filter device designed to overcome the drawbacks typically associated with known structures.

According to the present invention, there is provided a filter device as claimed in Claim 1.

Two preferred non-limiting embodiments of the present invention will be described by way of example with reference to the accompanying drawings, in which:

Fig.1 shows an architectural block diagram of one embodiment of the device according to the present invention;

Fig.2 shows a logic diagram of a component on the Fig.1 device;

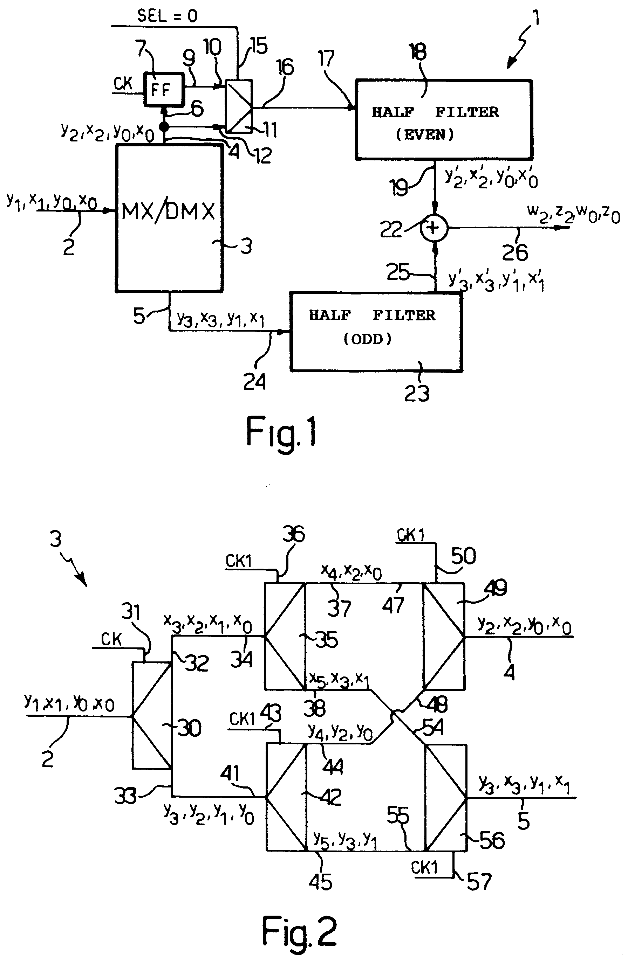

Fig.s 3 and 4 show logic diagrams of two components on the Fig.1 device;

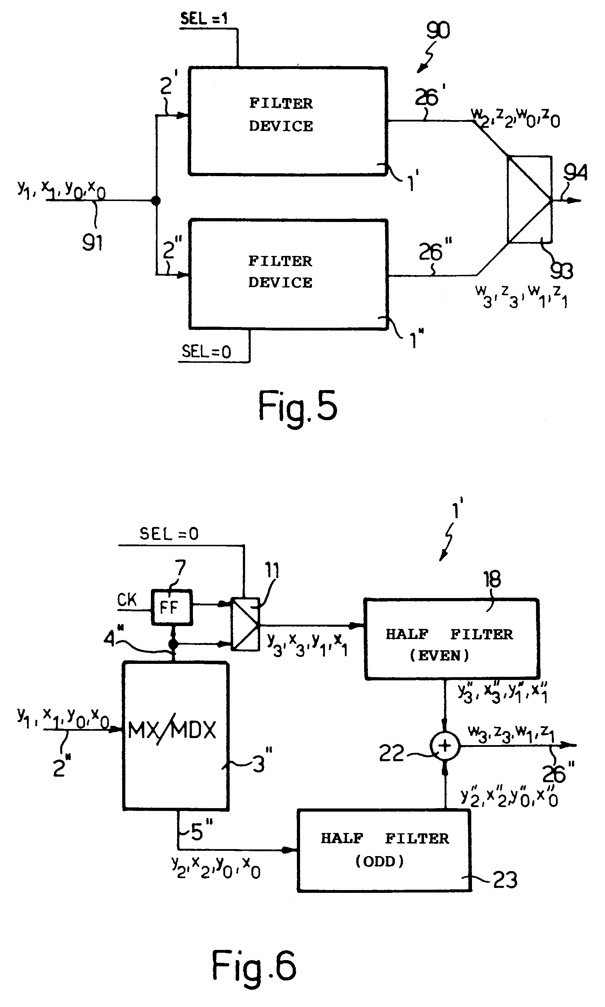

Fig.5 shows an architectural block diagram of a structure featuring the Fig.1 device;

Fig.6 shows a block diagram of a variation of the Fig.1 device as applied to the Fig.5 structure.

Number 1 in Fig.1 indicates a filter device having an input 2 supplied with a high-frequency input signal (in the example shown, of 80 MHz). The input signal comprises two different multiplexed channels, each with a sampling frequency of 40 MHz, to give a sequence of 8-bit samples $x_0$, $y_0$, $x_1$, $y_1$, $x_2$, ...,.

Input 2 is connected to a multiplexer/demultiplexer MX/DMX stage 3 (one embodiment of which is shown in Fig.2 and described later on) having two outputs 4 and 5 supplying two signals of half the frequency of the input signal (in this case, 40 MHz). In the example shown, outputs 4 and 5 respectively supply the even samples $x_0$, $y_0$, $x_2$, ... and the odd samples $x_1$, $y_1$, $x_3$, ... of the input signal.

Output 4 is connected to input 6 of a delay element 7 (e.g. a flip-flop) having a second input 8 supplied with an 80 MHz clock signal CK, and an output 9 supplying the samples delayed by 2T (T being the period of the input signal). Output 9 of delay element 7 is connected to a first input 10 of a switch 11 having a second input 12 connected directly to output 4 of multiplexer/demultiplexer stage 3, and a third selecting input 15 supplied with a logic signal SEL the logic value of which indicates which of the two signals at inputs 10 and 12 is to be transferred to output 16 of switch 11.

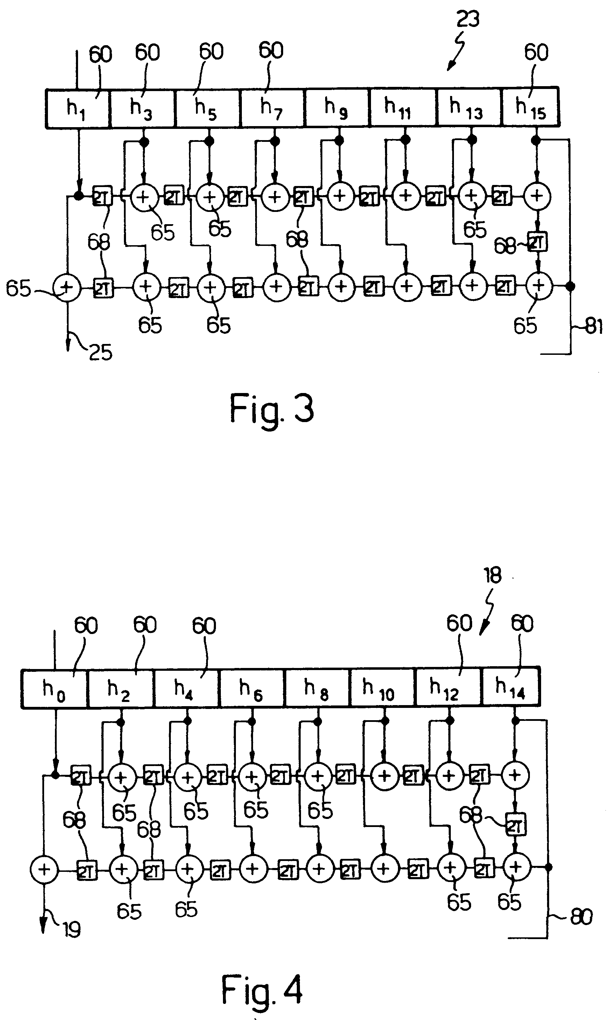

Output 16 of switch 11 is connected to input 17 of a first even-coefficient half filter 18 (illustrated in Fig.3 and described in detail later on) the output 19 of which is connected to an adding element 22.

Device 1 also comprises a second odd-coefficient half filter 23 (illustrated in Fig.4 and described in detail later on) having an input 24 connected directly to output 5 of multiplexer/demultiplexer stage 3, and an output 25 connected to adding element 22. The output 26 of adding element 22 defines the output of device 1.

As shown in Fig.2 illustrating the structure of multiplexer/demultiplexer stage 3, input 2 of stage 3 is connected to a first demultiplexer element 30 having a clock input 31 supplied with 80 MHz clock signal CK, and two outputs 32, 33 respectively supplying samples $x_0$, $x_1$, $x_2$, ... and $y_0$, $y_1$, $y_2$, ..., and so separating the two formerly multiplexed channels.

Output 32 of demultiplexer element 30 is connected to input 34 of a second demultiplexer element 35 having a clock input 36 supplied with a 40 MHz clock signal CK1, and two outputs 37, 38 respectively supplying the even samples $x_0$, $x_2$, $x_4$, ... and odd samples $x_1$, $x_3$, ... of the first channel at 20 Mz frequency. Similarly, output 33 of demultiplexer element 30 is connected to input 41 of a third demultiplexer element 42 having a clock input 43 supplied with 40 MHz clock signal CK1, and two outputs 44, 45 respectively supplying the even samples $y_0$, $y_2$, $y_4$, ... and odd samples $y_1$, $y_3$, ... of the second channel at 20 MHz frequency.

Output 37 of second demultiplexer element 35 and output 44 of third demultiplexer element 42 are connected respectively to a first and second input 47, 48 of a first multiplexer element 49 having a third input 50 supplied with 40 MHz clock signal CK1, and an output defining output 4 of stage 3 in Fig.1. Output 4 supplies the even sample sequence $x_0$, $y_0$, $x_2$, $y_2$ of both channels of the input signal to device 1. Similarly, output 38 of second demultiplexer element 35 and output 45 of third demultiplexer element 42 are connected respectively to a first and second input 54, 55 of a second multiplexer element 56 having a third input 57 supplied with 40 MHz clock signal CK1, and an output defining output 5 of stage 3, which supplies the odd sample sequence $x_1$, $y_1$, $x_3$, $y_3$ of both input signal channels.

Fig.s 3 and 4 show respective embodiments of half filters 23 and 18. Each channel requires a 16-coefficient filter for a normal asymmetrical structure, a 32-coefficient filter for symmetrical structures, and a 64-coefficient filter for half-band filters. The following description deals with a 16-coefficient filter which, in the preferred embodiment shown, is divided into two 8-coefficient half filters operating respectively on odd samples (using only odd outputs) and even samples (using only even outputs). Both said filters are preferably formed as shown in Fig.3 of Italian Patent Application 22890A/89 filed on 6 December 1989 by the present Applicant and entitled "Programmable digital filter". More specifically, filters 18, 23 are formed using EPROMs, and comprise a number of memory banks 60 containing in table form the partial products $h_i x_j$ and $h_k y_l$ of all the possible levels of input samples $x_j$, $y_l$. As input samples $x_j$, $y_l$ are employed as memory bank read addresses, the memory cell in each bank having the address specified by the corresponding bit in the input sample contains the appropriate partial product which it supplies to the output. The output of each bank 60 (with the exception of the banks relative to coefficients $h_0$, $h_1$) is connected to two adders 65, and each adder is connected to the output of the foregoing one via a respective delay element 68 for generating a delay of 2T. As can be seen, the chain of adders 65 runs back on itself, and the outputs of banks 60 are applied to the two adders 65 located symmetrically in relation to the center point of the chain. Filters 18, 23 each present two outputs: a respective symmetrical output 19, 25 at the end of the respective chain of adders; and a respective asymmetrical output 80, 81.

The filter device shown in Fig.s 1-4 operates as follows. Multiplexer/demultiplexer stage 3 separates the even and odd samples in the input signal as described with reference to Fig.2, during which phase, one of the two groups of samples, e.g. the odd samples, are delayed by time T so as to be synchronized perfectly with the samples in the other group. The even and odd samples are then filtered by filters 18, 23 to give samples $x'_0$, $y'_0$, $x'_2$, $y'_2$, ..., and $x'_1$, $y'_1$, $x'_3$, $y'_3$, ..., which are added in twos to give at output 26 of device 1 a series of samples $z_0$, $w_0$, $z_2$, $w_2$, ...,
where:

$$z_i = x'_i + x'_{i+1}$$
$$w_i = y'_i + y'_{i+1} \quad (i = \text{even number}),$$

at 40 MHz frequency, i.e. half the input frequency.

The architecture according to the present invention may also be employed to the same advantage in cases requiring no reduction in sampling frequency at the output. In this case, in fact, it is possible to employ a double (multichip) configuration in which the filter device is appropriately duplicated by first reducing the filtering frequency and then restoring it to its original value. One embodiment of such a configuration is shown in Fig.5 and described below.

The Fig.5 structure, indicated as a whole by 90, comprises two filter devices 1' and 1'', the inputs 2' and 2'' of which are both connected to input 91 of structure 90 and therefore both supplied with the same input signal.

More specifically, device 1', which is enabled by the SEL signal, is similar to that described with reference to Fig.1, except that delay element 7 (and respective switch 11) is located on the odd sample line, i.e. is connected to output 5 of stage 3 as opposed to even sample output 4. On device 1'', on the other hand, the even samples are supplied to the odd half filter, and vice versa, as shown in detail in Fig.6 and described below. Outputs 26' and 26'' of devices 1' and 1'' are supplied to the input of a multiplexer element 93, the output 94 of which alternatively supplies the samples received from devices 1' and 1''.

As shown in Fig.6, device 1'' comprises a multiplexer/demultiplexer stage 3'' like stage 3 in Fig.2 and having two outputs 4'' and 5'' again supplying two data streams at half the input data frequency. Unlike stage 3, however, stage 3'' supplies the odd samples $x_1$, $y_1$, $x_3$, ... in the input signal to output 4'' and the even samples $x_0$, $y_0$, $x_2$, ... to output 5''. The rest of device 1'' in Fig.6 is as described with reference to Fig.1, that is, output 4'' of stage 3'' is connected both to a delay element 7 (e.g. a flip-flop also supplied with 80 MHz clock signal CK) and to a switch or multiplexer 11 supplied with logic signal SEL.

The output of switch 11 is connected to a first even-coefficient half filter 18 structured as in Fig.4 and output-connected to adding element 22; and output 5'' of stage 3'' is again connected to second odd-coefficient half filter 23 structured as in Fig.3 and also output-connected to adding element 22.

As already stated, filter device 1' in the Fig.5 structure is controlled (by the SEL signal) so that the odd samples are delayed by time 2T. Consequently, the output of odd half filter 23 of device 1' in Fig.5 is delayed by 2T in relation to the output of even half filter 18, so that outputs 19 and 25 respectively present the following sequences:
... $x_4$, $y_2$, $x_2$, $y_0$, $x_0$
... $x_3$, $y_1$, $x_1$
and output 26 of adder 22 presents samples $z_1$, $w_1$, $z_3$, $w_3$ ...,
where:

$$z_i = x'_i + x'_{i+1}$$
$$w_i = y'_i + y'_{i+1} \quad (i = \text{odd number}).$$

On filter device 1'', the outputs of half filters 18 and 23 respectively present the following se-

quences:

... $y''_2, x''_2, y''_0, x''_0$

... $y''_3, x''_3, y''_1, x''_1$

and output 26'' of adder 22 presents the following sequence:

... $w_2, z_2, w_0, z_0$

where:

$z_i = x''_i + x''_{i+1}$
$w_i = y''_i + y''_{i+1}$ (i = even number).

If a reduction in output frequency is required, the samples at one only of outputs 26', 26'' are employed; otherwise the samples at both outputs are employed and multiplexer element 93 supplies samples $z_0, w_0, z_1, w_1, z_2, ..$, at the original 80 MHz frequency at output 94.

The advantages of the device according to the present invention will be clear from the foregoing description. Firstly, by virtue of reducing the operating frequency prior to filtering, the device provides for operating on samples with a very high input frequency, e.g. equal to twice the maximum operating frequency of the filters.

Secondly, by virtue of the structure provided, wherein actual filtering is performed by two parallel-operating half filters, two multiplexed channels may be processed using the same filtration pattern and with a 1:2 reduction per channel.

Thirdly, implementation of the half filters as lookup tables containing all the possible products of all the possible input combinations is particularly advantageous by eliminating the need for hardware multipliers. The half filters may be adapted to the type of filter required via off-line programming, and the products may be programmed prior to use via specially designed programs loadable also on personal computers.

Fourthly, as described with reference to Fig.s 5 and 6, the same solution may also be employed to the same advantage in cases not requiring a reduction in frequency, with no need for external circuitry and simply on the basis of an external logic signal. Finally, the solution described may be implemented on VLSI circuits, and requires only a very small area.

To those skilled in the art it will be clear that changes may be made to the device as described and illustrated herein without, however, departing from the scope of the present invention. For example, the delay element may be provided at both outputs of stage 3, or even dispensed with entirely; and, though the solution described is particularly advantageous, the filters may be formed in any manner.

## Claims

1. A digital filter device (1, 1', 1'') comprising an input (2) supplied with an input signal including a number of unfiltered samples; a digital filter (18, 23); and an output (26) supplying an output signal including a number of filtered samples; characterized by the fact that it comprises frequency dividing means (3, 3'') between said input (2) and said digital filter (18, 23).

2. A device as claimed in Claim 1, characterized by the fact that said digital filter comprises a first and second half filter (18, 23); and by the fact that said frequency dividing means (3, 3'') present a first and second output (4, 4'', 5, 5'') respectively connected to said first and second half filters.

3. A device as claimed in Claim 2, characterized by the fact that said first and second output (4, 5) of said frequency dividing means (3) respectively supply even and odd samples of said input signal; and by the fact that said first and second half filters (18, 23) present respective filtering coefficients; one (18) of said first and second half filters presenting even filtering coefficients; and the other (23) of said first and second half filters presenting odd filtering coefficients.

4. A device as claimed in one of the foregoing Claims from 1 to 3, characterized by the fact that said frequency dividing means comprise a multiplexer/demultiplexer stage (3, 3', 3'').

5. A device as claimed in Claim 4, characterized by the fact that said multiplexer/demultiplexer stage (3, 3'') comprises a first demultiplexer element (30) having an input connected to said input (2) of said filter device (1), and two outputs (32, 33); a first output (32) of said first demultiplexer element being connected to an input (34) of a second demultiplexer element (35) having two outputs (37, 38); a second output (33) of said first demultiplexer element being connected to an input (41) of a third demultiplexer element (42) having two outputs (44, 45); a first output (37, 44) of said second and third demultiplexer elements being connected to a respective input (47, 48) of a first multiplexer element (49); and a second output (38, 45) of said second and third demultiplexer elements being connected to a respective input (54, 55) of a second multiplexer element (56).

6. A device as claimed in one of the foregoing Claims from 2 to 5, characterized by the fact that said half filters (18, 23) comprise memory banks addressed by said unfiltered samples and storing all the products of the filtering coefficients of said half filters for all the possible values of said unfiltered samples.

7. A device as claimed in one of the foregoing Claims from 2 to 6, characterized by the fact that a delay element (7) is provided between one (4) of said first and second outputs (4, 5) of said frequency dividing means (3) and a respective half filter (18).

8. A device as claimed in Claim 7, characterized by the fact that it comprises a controllable switch (11) having an output (16) connected to said respective half filter (18), a first input (12) connected to said one (4) of said first and second outputs of said frequency dividing means (3), a second input (10) connected to the output (9) of said delay element (7), and a third input (15) supplied with a selecting signal for selectively connecting one of said first and second inputs of said switch to said respective half filter.

9. A device as claimed in one of the foregoing Claims from 2 to 8, characterized by the fact that it comprises an adding element (22) having a first and second input connected respectively to the output (19, 25) of said first and second half filters (18, 23).

10. A digital filter structure (90) comprising an input (91) supplied with an input signal including a number of unfiltered samples; a digital filter (3, 3''); and an output (94) supplying an output signal including a number of filtered samples; characterized by the fact that it comprises two digital filter devices (1', 1'') each having an input (2', 2'') connected to said input (91) of said digital filter structure, a respective filtering element (18, 23), and a respective output (26', 26''); each said filter device comprising frequency dividing means (3, 3'') located between said respective input and said digital filter.

11. A structure as claimed in Claim 10, characterized by the fact that it comprises a multiplexer element (93) having a first and second input connected to a respective output (26', 26'') of said first and second digital filter devices (1', 1'').

Fig.1

Fig.2

Fig. 3

Fig. 4

Fig.5

Fig.6

<table>
<tr><td colspan="2"></td><td>European Patent<br>Office</td><td>EUROPEAN SEARCH REPORT</td><td>Application Number<br><br>EP 92 83 0429</td></tr>
</table>

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | ELEKTRONIK.<br>vol. 40, no. 9, 30 April 1991, MUNCHEN DE<br>pages 54 - 62 , XP228326<br>F. ISBANNER 'VIDEOCODEC- VOLLSTÄNDIG DIGITAL' | 1-3,7,9 | H03H1/00<br>H03H17/02<br>H03H17/06 |
| A | * page 61, line 1 - page 62, column 1, line 2; figure 4 * | 11 | |
| A | PHILIPS TECHNICAL REVIEW<br>vol. 42, no. 6/7, April 1986, EINDHOVEN NL<br>pages 230 - 238<br>J.VAN DER KAM 'A DIGITAL DECIMATING FILTER FOR ANALOG-TO-DIGITAL CONVERSION OF AUDIO SIGNALS'<br>* page 235, column 2, line 1 - page 236, column 2, line 15; figure 8 * | 6 | |
| | ----- | | **TECHNICAL FIELDS SEARCHED (Int. Cl.5)**<br><br>H03H |

The present search report has been drawn up for all claims

| Place of search | Date of completion of the search | Examiner |
|---|---|---|
| THE HAGUE | 18 MAY 1993 | COPPIETERS C. |

EPO FORM 1503 03.82 (P0401)

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document